# FASCICULE DE BREVET EUROPEEN

(11) **EP 2 723 525 B1**
(45) Date de publication et mention de la délivrance du brevet: **19.08.2015**
(21) Numéro de dépôt: 12728598.9
(22) Date de dépôt: 21.06.2012
(51) Int. Cl.: B22F 1/02, G21C 3/42, C22C 43/00, G21C 3/60, G21C 21/02, B22F 3/00, C23C 14/08, C23C 14/22, C22C 1/04, C22C 1/10, C23C 16/40, C23C 16/44, C22C 21/02

(54) **POUDRE D'UN ALLIAGE A BASE D'URANIUM COMPRENANT DU MOLYBDENE, EN PHASE GAMMA-METASTABLE, COMPOSITION DE POUDRES COMPRENANT CETTE POUDRE, ET UTILISATIONS DESDITES POUDRE ET COMPOSITION**
PULVER AUS EINER LEGIERUNG AUF DER BASIS VON URAN ENTHALTEND MOLYBDÄN, IN GAMMA-METASTABILER PHASE, ZUSAMMENSETZUNG AUS PULVERN MIT DIESEM PULVER UND VERWENDUNGEN DIESES PULVERS UND DER ZUSAMMENSETZUNG
POWDER OF AN ALLOY BASED ON URANIUM COMPRISING MOLYBDENUM, IN GAMMA-METASTABLE PHASE, COMPOSITION OF POWDERS COMPRISING THIS POWDER, AND USES OF SAID POWDER AND COMPOSITION

(30) Priorité: 23.06.2011 FR 1155551
(43) Date de publication de la demande: 30.04.2014
(73) Titulaire: Commissariat à l'Énergie Atomique et aux Énergies Alternatives, 75015 Paris (FR)
(72) Inventeur: ALLENOU, Jérôme, F-22800 Le Vieux Bourg (FR); ILTIS, Xavière, F-04860 Pierrevert (FR); CHAROLLAIS, François, F-84530 Villelaure (FR); TOUGAIT, Olivier, F-35000 Rennes (FR); PASTUREL, Mathieu, F-35440 Montreuil-sur-ille (FR); DEPUTIER, Stéphanie, F-35000 Rennes (FR)
(74) Mandataire: Ahner, Philippe
(86) Numéro de dépôt international: PCT/EP2012/061938
(87) Numéro de publication internationale: WO 2012/175596

(56) Documents cités:
- US-A- 5 978 432
- J. ALLENOU ET AL.: "Interdiffusion behaviours in doped molybdenum uranium and aluminum or aluminum silicoon dispersion fuels: Effects of the microstructure", JOURNAL OF NUCLEAR MATERIALS, no. 416, 24 février 2011 (2011-02-24), pages 205-210, XP009153540, DOI: 10.1016/j.jnucmat.2011.01.130
- J. ALLENOU ET AL.: "U-Mo/Al-Si interaction: Influence of Si concentration", JOURNAL OF NUCLEAR MATERIALS, no. 399, 27 janvier 2010 (2010-01-27), pages 189-199, XP009153541, DOI: 10.1016/j.nucmat.2010.01.018

## Description

### DOMAINE TECHNIQUE

La présente invention se rapporte à une poudre d'un alliage à base d'uranium et comprenant du molybdène en phase γ-métastable et, en particulier à une poudre d'un alliage binaire U(Mo) ou d'un alliage ternaire U(MoX) où X représente un élément chimique autre que l'uranium et le molybdène.

Elle se rapporte également à une composition de poudres comprenant cette poudre d'alliage, en mélange avec une poudre comprenant de l'aluminium.

Elle se rapporte aussi aux utilisations de ladite poudre d'alliage et de ladite composition de poudres.

Une telle poudre d'alliage et une telle composition de poudres sont, en effet, susceptibles d'être utilisées pour la fabrication d'éléments combustibles nucléaires et, notamment, d'éléments combustibles pour réacteurs nucléaires expérimentaux, plus connus sous le sigle MTR (pour « **M**aterial **T**esting **R**eactor »), tels que le Réacteur Jules Horowitz (RJH) du CEA Cadarache (France), le Réacteur à Haut Flux (RHF) de l'Institut Laue-Langevin de Grenoble (France) ou encore le réacteur à haut flux neutronique BR-2 du site de Mol (Belgique).

Elles sont également susceptibles d'être utilisées pour la fabrication de cibles destinées à la production de radioéléments, utiles notamment pour l'imagerie médicale comme, par exemple, le technétium 99m.

La présente invention se rapporte encore à un procédé de fabrication d'un élément combustible nucléaire ou d'une cible pour la production d'un radioélément, ainsi qu'à un élément combustible nucléaire et à une cible pour la production d'un radioélément, qui est obtenu(e) par ce procédé.

### ÉTAT DE LA TECHNIQUE ANTÉRIEURE

Jusque dans les années 1950, les combustibles dédiés aux MTR étaient essentiellement constitués d'alliages d'uranium et d'aluminium présentant une teneur massique en uranium 235 de 93% pour une charge spécifique de 1,2 g d'uranium par cm³.

A partir de 1977 et sous l'impulsion des Etats-Unis d'Amérique, un programme visant à réduire les risques de prolifération des armes nucléaires et, donc, à abaisser le taux d'enrichissement en uranium des combustibles dédiés aux MTR a été mis en place au niveau international. Il s'agit du programme RERTR (pour « ***R**educed **E**nrichment for **R**esearch and **T**est **R**eactor* »).

Dès lors, la mise au point de nouveaux alliages d'uranium qui soient capables de servir de combustibles nucléaires dans des MTR tout en présentant une teneur massique en uranium 235 ne dépassant pas 20%, a donné lieu à de nombreuses études.

Ont ainsi été notamment étudiés des alliages à base d'uranium et de silicium et des alliages à base d'uranium et de molybdène.

Ce dernier type d'alliage est celui qui présente les propriétés les plus intéressantes puisqu'il permet notamment d'atteindre une charge spécifique de 8,5 g d'uranium par cm³ de combustible alors que cette charge n'est au mieux que de 4,8 g d'uranium par cm³ pour les siliciures d'uranium.

Initialement, il a été proposé d'utiliser les alliages à base d'uranium et de molybdène sous forme dispersée dans une matrice d'aluminium parce que l'aluminium présente une bonne transparence aux neutrons, une bonne résistance à la corrosion par l'eau et de bonnes propriétés mécaniques pour des températures avoisinant les 100°C.

Toutefois, il s'avère que les combustibles nucléaires qui sont composés d'un alliage à base d'uranium et de molybdène dispersé dans une matrice d'aluminium présentent un mauvais comportement sous irradiation neutronique, même à des niveaux de sollicitation relativement modérés. Ceci est notamment dû au fait que, sous irradiation neutronique, l'alliage à base d'uranium et de molybdène interagit avec l'aluminium qui l'entoure, ce qui conduit à la formation de composés riches en aluminium tels qu'UAl₄ et U₆Mo₄Al₄₃, qui sont néfastes dans les conditions d'utilisation (références **[1]** à **[4]**).

Pour pallier ce problème, il a ensuite été proposé d'utiliser non plus une matrice d'aluminium mais une matrice constituée d'un alliage d'aluminium et de silicium.

En effet, il a été montré que, sous l'effet des traitements thermiques qui sont appliqués aux éléments combustibles nucléaires lors de leur fabrication, le silicium présent dans la matrice sous forme de précipités diffuse vers les particules d'alliage U(Mo) donnant lieu à la formation, autour de ces particules, d'une couche d'interaction riche en silicium.

Cette couche d'interaction riche en silicium possède des propriétés physiques spécifiques qui lui permettent de rester stable sous irradiation neutronique et de réduire la diffusion de l'aluminium vers l'alliage à base d'uranium et de molybdène et, par la même, les interactions U(Mo)-aluminium.

Au surplus, sous irradiation neutronique, les précipités de silicium qui sont situés à proximité des particules d'alliage U(Mo) contribuent à renforcer la stabilisation de la couche d'interaction riche en silicium déjà formée et son rôle protecteur vis-à-vis de la diffusion de l'aluminium.

L'intérêt de l'utilisation d'une matrice constituée d'un alliage d'aluminium et de silicium a été validé par des essais sous irradiation neutronique en réacteur MTR dans des conditions moyennement sollicitantes (références **[5]** à **[8]**).

Toutefois, de nombreuses incertitudes pèsent sur l'aptitude d'une telle matrice à améliorer le comportement de combustibles nucléaires à base d'uranium et de molybdène dans le cas où ces combustibles seraient soumis à des irradiations plus fortement sollicitantes que celles utilisées dans les références **[5]** à **[8]** précitées, comme, par exemple, une irradiation d'une puissance surfacique de 500 W/cm² avec un taux de consommation en uranium 235 supérieur à 50%.

Les Inventeurs se sont donc fixé pour but de trouver un moyen qui permette de conférer à des combustibles nucléaires à base d'uranium et de molybdène un comportement très satisfaisant sous irradiation neutronique, y compris lorsque ces combustibles sont irradiés dans des conditions fortement sollicitantes.

Plus spécifiquement, ils se sont fixé pour but de parvenir à réduire au maximum les interactions susceptibles de se produire, sous irradiation neutronique, entre un alliage à base d'uranium et de molybdène et l'aluminium de la matrice dans laquelle cet alliage est dispersé et ce, que cette matrice soit uniquement constituée d'aluminium ou d'un alliage d'aluminium et de silicium.

### EXPOSÉ DE L'INVENTION

Ces buts et d'autres encore sont atteints par l'invention qui propose, en premier lieu, une poudre selon la revendication 1 d'un alliage à base d'uranium et comprenant du molybdène en phase γ-métastable, laquelle poudre est formée de particules comportant un coeur qui est constitué dudit alliage et qui est revêtu d'une couche d'alumine située au contact de ce coeur.

En effet, dans le cadre de leurs travaux, les Inventeurs ont constaté que, de manière surprenante, le dépôt d'une couche d'alumine sur des particules d'un alliage à base d'uranium et comprenant du molybdène a pour effet :
- dans le cas où les particules d'alliage sont ensuite dispersées dans une matrice d'aluminium, de créer à la surface de ces particules une barrière vis-à-vis de la diffusion de l'aluminium sous irradiation neutronique ; cette barrière permet, selon son épaisseur, de réduire très fortement voire de supprimer totalement l'existence d'interactions U(Mo)-aluminium et donc la formation de composés riches en aluminium, au comportement néfaste sous irradiation neutronique ; et
- dans le cas où les particules d'alliage sont ensuite dispersées dans une matrice d'aluminium et de silicium, d'augmenter la vitesse à laquelle diffuse le silicium vers ces particules lors des traitements thermiques qui sont appliqués au cours de la fabrication des éléments combustibles nucléaires, et d'induire ainsi la formation d'une couche d'interaction plus riche en silicium et plus épaisse - et donc plus protectrice vis-à-vis de la diffusion de l'aluminium sous irradiation neutronique - que celle obtenue dans les références [5] à [8] précitées.

Dans un cas comme dans l'autre, ces effets sont de nature à entraîner une réduction du volume d'interaction entre les particules fissiles uranifères et la matrice aluminium au sein du combustible nucléaire, une meilleure solubilisation et une meilleure rétention des gaz de fission sous irradiation neutronique, une diminution du gonflement des combustibles nucléaires et, à la clé, un comportement de ces combustibles très amélioré, y compris lorsqu'ils sont irradiés dans des conditions fortement sollicitantes.

Conformément à l'invention, la couche d'alumine qui recouvre le coeur des particules de l'alliage présente avantageusement une épaisseur au moins égale à 50 nm et allant, de préférence, de 50 nm à 3 µm (par exemple, 50 nm, 100 nm, 150 nm, 200 nm, 250 nm, 300 nm, 350 nm, 400 nm, 450 nm, 500 nm, 550 nm, etc) et, mieux encore, de 100 nm à 1000 nm.

Cette couche d'alumine peut être déposée par toute technique qui permet de recouvrir des particules métalliques d'une couche mince d'un métal ou d'un oxyde métallique et, notamment, par :
- la technique de dépôt chimique en phase vapeur, plus souvent désignée par le sigle CVD (« ***C**hemical **V**apor **D**eposition* »), sous toutes ses formes : CVD thermique conventionnelle, CVD par décomposition d'organométalliques (ou MOCVD), CVD à pression atmosphérique (ou APCVD), CVD basse pression (ou LPCVD), CVD sous vide poussé (ou UHVCVD), CVD assisté par aérosol (ou AACVD), CVD par injection directe liquide (ou DLICVD), CVD thermique rapide (ou RTCVD), CVD initié (ou i-CVD), CVD par couche atomique (ou ALCVD), CVD à fil chaud (ou HWCVD), CVD assisté par plasma (ou PECVD), CVD assisté par plasma déporté (ou RPECVD), CVD assisté par plasma micro-ondes (ou MWPCVD), etc ;
- la technique de dépôt physique en phase vapeur, plus souvent désignée par le sigle PVD (pour « ***P**hysical **V**apor **D**eposition* »), sous toutes ses formes : PVD par pulvérisation cathodique, PVD par évaporation sous vide, PVD par pulvérisation par faisceau d'ions, PVD par arc, par exemple cathodique, dépôt par ablation laser, plus souvent désigné par le sigle PLD (pour « ***P**ulsed **L**aser **D**eposition* »), etc ; et
- la technique de dépôt hybride physico-chimique en phase vapeur, plus souvent désignée par le sigle HPCVD (pour « ***H**ybrid **P**hysical-**C**hemical **V**apor **De**position* ») ;
- la technique de dépôt par action mécanique, qui consiste à provoquer une forte adhésion de particules submicroniques (particules d'enrobage) sur la surface de particules micrométriques (particules substrats), sous toutes ses formes : mécanofusion, procédé « hybridizer » tel que décrit dans la référence **[9]**, enrobage par collision magnétiquement assistée, lit fluidisé rotatif, broyeur thêta, mixeur à cisaillement élevé, granulateur à pression modulée.

Conformément à l'invention, la poudre d'alliage est, de préférence, formée de particules dont les dimensions, telles que déterminées par diffraction et diffusion laser, vont de 1 à 300 µm et, mieux encore, de 20 à 100 µm.

L'alliage à base d'uranium et comprenant du molybdène, qui forme le coeur des particules de cette poudre, est de préférence :
- soit un alliage binaire U(Mo), c'est-à-dire un alliage uniquement constitué d'uranium et de molybdène, auquel cas le molybdène représente préférentiellement de 5 à 15% massiques et, mieux encore, de 7 à 10% massiques de cet alliage ;
- soit un alliage ternaire U(MoX) dans lequel X représente un élément chimique différent de l'uranium et du molybdène, propre à améliorer encore le comportement des combustibles nucléaires sous irradiation neutronique, auquel cas le molybdène représente préférentiellement de 5 à 15% massiques et, mieux encore, de 7 à 10% massiques de cet alliage tandis que X, qui peut notamment être un métal comme le titane, le zirconium, le chrome, le niobium, le platine, l'étain, le bismuth, le ruthénium ou le palladium, ou un semiconducteur comme le silicium, représente typiquement au plus 6% massiques de l'alliage et, mieux encore, au plus 4% massiques dudit alliage.

Conformément à l'invention, cet alliage peut être préparé par tout procédé connu permettant de fabriquer un alliage à base d'uranium et comprenant du molybdène en phase γ-métastable sous la forme d'une poudre et, notamment, par les procédés dits de *« fusion-atomisation* » tels que décrits dans les références **[10]** à **[12]**, les procédés dits de « *fusion-fragmentation mécanique* », les procédés dits de « *fusion-fragmentation chimique »* et tout procédé dérivé de ceux-ci.

L'invention a aussi pour objet une composition de poudres, qui comprend une poudre d'un alliage à base d'uranium et comprenant du molybdène en phase γ-métastable telle que précédemment décrite, mélangée à une poudre comprenant de l'aluminium, la teneur massique en aluminium de cette poudre étant au moins égale à 80%.

Dans cette composition de poudres, la poudre comprenant de l'aluminium est préférentiellement une poudre d'aluminium (c'est-à-dire une poudre qui ne contient que de l'aluminium) ou bien une poudre d'un alliage comprenant de l'aluminium et du silicium, par exemple une poudre d'un alliage binaire Al(Si), auquel cas l'aluminium représente typiquement de 88 à 98% massiques et, mieux encore, de 92 à 96% massiques de cet alliage tandis que le silicium représente typiquement de 2 à 12% massiques et, mieux encore, de 4 à 8% massiques de cet alliage.

Dans tous les cas, la poudre d'alliage à base d'uranium et comprenant du molybdène en phase γ-métastable représente, de préférence, de 65 à 90% massiques et, mieux encore, de 80 à 90% massiques de la composition de poudres.

L'invention a également pour objet l'utilisation d'une poudre d'un alliage à base d'uranium et comprenant du molybdène en phase γ-métastable telle que précédemment décrite, ou d'une composition de poudres telle que précédemment décrite, pour la fabrication d'éléments combustibles nucléaires et, notamment, d'éléments combustibles pour réacteurs nucléaires expérimentaux tels que le Réacteur Jules Horowitz (RJH) du CEA Cadarache (France), le Réacteur à Haut Flux (RHF) de l'Institut Laue-Langevin de Grenoble (France) ou encore le réacteur à haut flux neutronique BR-2 du site de Mol (Belgique).

Elle a en outre pour objet l'utilisation d'une poudre d'un alliage à base d'uranium et comprenant du molybdène en phase γ-métastable telle que précédemment décrite, ou d'une composition de poudres telle que précédemment décrite, pour la fabrication de cibles destinées à la production de radioéléments, utiles notamment pour l'imagerie médicale comme, par exemple, le technétium 99m.

L'invention a encore pour objet un procédé de fabrication d'un élément combustible nucléaire ou d'une cible pour la production d'un radioélément, qui comprend le remplissage d'une gaine avec une composition de poudres telle que précédemment décrite, et l'application d'au moins un traitement thermique à l'ensemble ainsi obtenu.

Dans un premier mode de mise en oeuvre préféré de ce procédé, la poudre comprenant de l'aluminium, qui est présente dans la composition de poudres, est une poudre d'aluminium. Auquel cas, l'élément combustible nucléaire ou la cible pour la production d'un radioélément, qui est obtenu(e) par ce procédé, comprend une gaine dans laquelle est logée une âme et cette âme est formée d'une matrice en aluminium dans laquelle sont dispersées des particules, ces particules comportant un coeur qui est constitué d'un alliage à base d'uranium et comprenant du molybdène en phase γ-métastable, et qui est revêtu d'une couche d'alumine située au contact de ce coeur.

Dans un autre mode de mise en oeuvre du procédé selon l'invention, la poudre comprenant de l'aluminium, qui est présente dans la composition de poudres, est une poudre d'un alliage comprenant de l'aluminium et du silicium, par exemple une poudre d'un alliage binaire Al(Si). Auquel cas, l'élément combustible nucléaire ou la cible pour la production d'un radioélément, qui est obtenu(e) par ce procédé, comprend une gaine dans laquelle est logée une âme et cette âme est formée d'une matrice comprenant de l'aluminium et du silicium et dans laquelle sont dispersées des particules, ces particules comportant un coeur qui est constitué d'un alliage à base d'uranium et comprenant du molybdène en phase γ-métastable, et qui est revêtu d'une couche contenant de l'uranium, du molybdène, de l'aluminium et du silicium, qui est située au contact de ce coeur, dont la teneur en silicium est au moins égale à 50% atomique au contact dudit coeur et qui est elle-même revêtue d'une couche d'alumine.

Dans tous les cas, l'élément combustible nucléaire ou la cible pour la production d'un radioélément se présente avantageusement sous la forme d'une plaque ou d'un crayon.

D'autres caractéristiques et avantages de l'invention ressortiront du complément de description qui suit, qui se rapporte à des exemples de dépôt d'une couche d'alumine sur des substrats massifs d'un alliage binaire d'uranium et de molybdène et de démonstration de la réactivité chimique des substrats ainsi obtenus en présence d'aluminium et d'un alliage d'aluminium et de silicium.

Il va de soi que ces exemples ne sont donnés qu'à titre d'illustrations de l'objet de l'invention et ne constituent en aucun cas une limitation de cet objet.

Il est à noter que, si les exemples qui sont rapportés ci-après ont été réalisés en utilisant un alliage binaire U(Mo) sous la forme de substrats massifs et non pas sous la forme d'une poudre, c'est uniquement pour des raisons de sécurité pour les expérimentateurs, la manipulation de poudres à base d'uranium étant, en effet, plus délicate et plus risquée que celle de substrats massifs.

Cela est toutefois sans incidence sur la validité des résultats expérimentaux obtenus.

### BRÈVE DESCRIPTION DES FIGURES

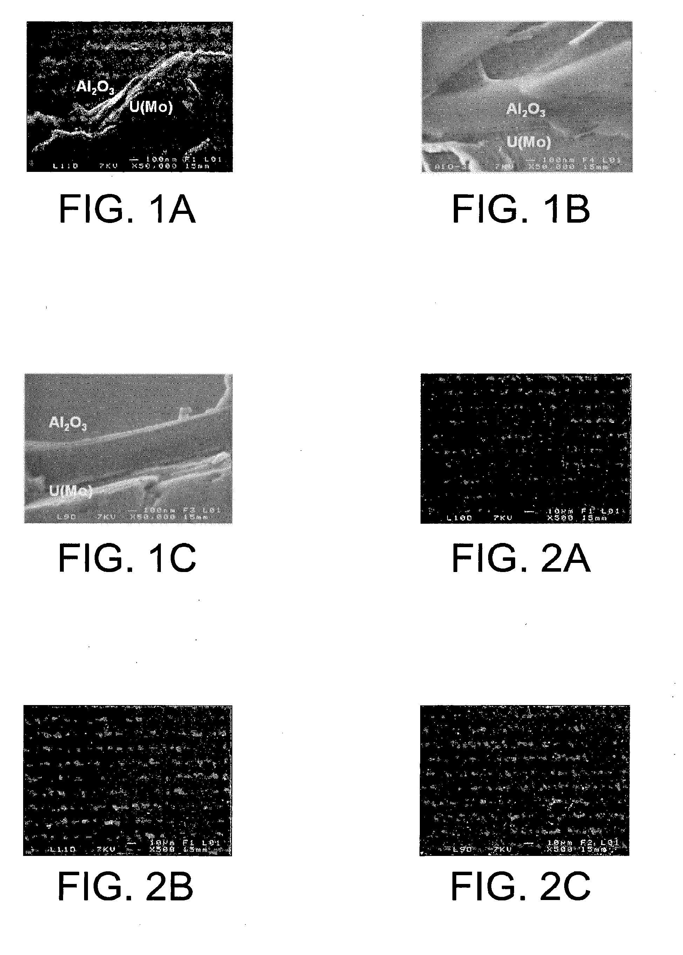

Les figures 1A, 1B et 1C représentent des images prises au microscope électronique à balayage (MEB) en mode électrons secondaires, à un grandissement de 50 000, montrant l'épaisseur de couches d'alumine ayant été déposées sur des substrats massifs en un alliage d'uranium et de molybdène à 8% massique de molybdène en phase γ-métastable (dénommé ci-après « *alliage γ-U(8Mo)* ») ; la figure 1A correspond au dépôt d'une couche d'alumine de 50 nm environ d'épaisseur, la figure 1B correspond au dépôt d'une couche d'alumine de 100 nm environ d'épaisseur tandis que la figure 1C correspond au dépôt d'une couche d'alumine de 400 nm environ d'épaisseur.
Les figures 2A, 2B et 2C représentent des images prises au MEB en mode électrons secondaires, à un grandissement de 500, montrant l'état de surface des couches d'alumine montrées respectivement sur les figures 1A, 1B et 1C.

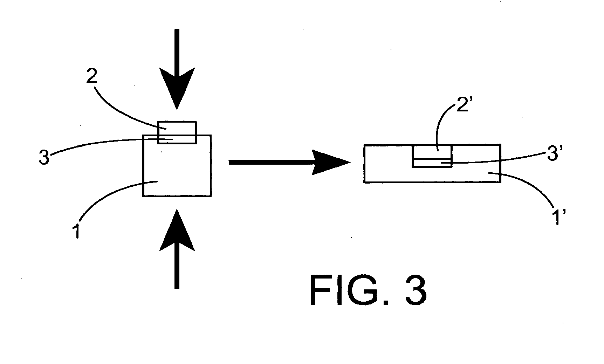

La figure 3 représente schématiquement la manière dont est encastré un substrat massif en un alliage γ-U(8Mo), ayant été revêtu d'une couche d'alumine, dans une pièce en aluminium ou en un alliage d'aluminium et de silicium à 7% massique de silicium (dénommé ci-après « *alliage Al(7Si)* »), en vue de tester la réactivité chimique de l'alliage γ-U(8Mo) en présence d'aluminium et d'un alliage d'aluminium et de silicium, en couple de diffusion activé par un traitement thermique.

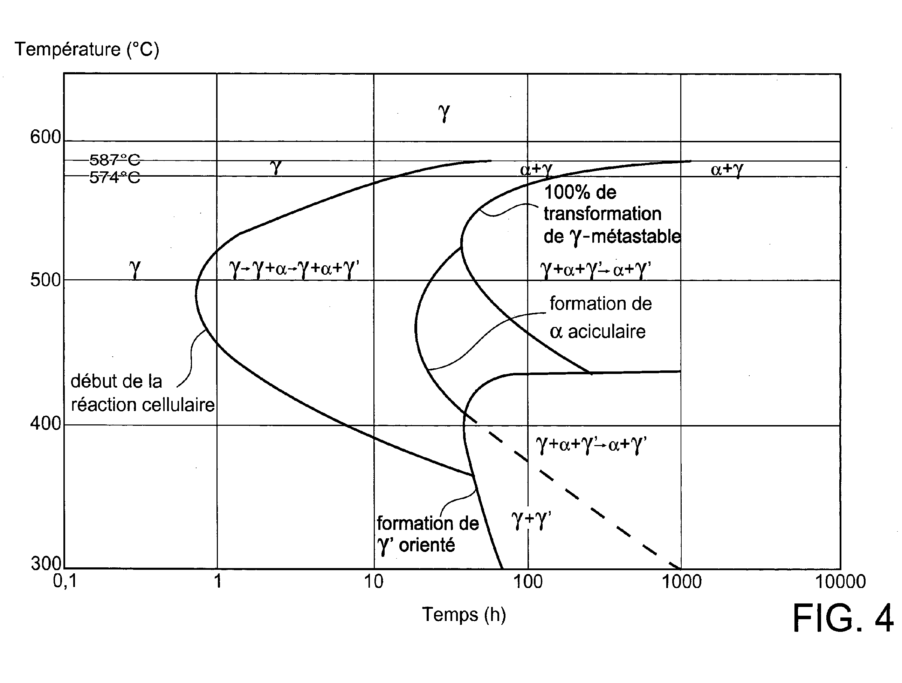

La figure 4 représente la courbe TTT (Température - Temps - Transformation) d'un alliage γ-U(8Mo), permettant de déterminer, pour une température donnée en degrés Celsius, le temps en heures au bout duquel la phase γ de cet alliage est déstabilisée.

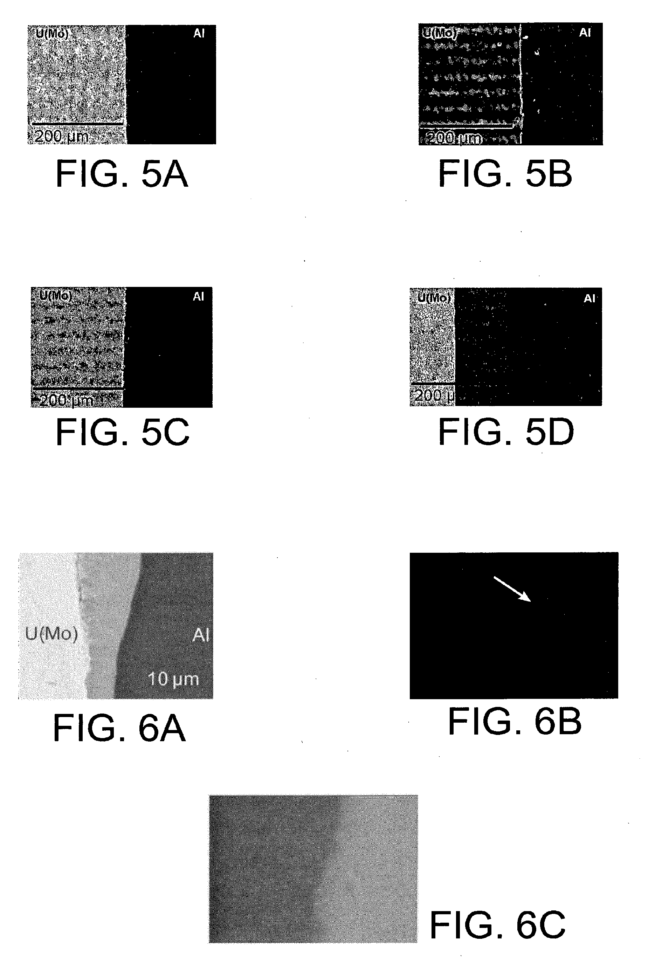

Les figures 5A, 5B, 5C représentent des images prises au MEB en mode électrons rétrodiffusés, à un grandissement de 200, montrant l'interface γ-U(8Mo)/Al de couples de diffusion composés d'un substrat massif en un alliage γ-U(8Mo), revêtu d'une couche d'alumine, et d'aluminium ; la figure 5A correspond à un couple de diffusion dans lequel la couche d'alumine mesure 50 nm environ d'épaisseur; la figure 5B correspond à un couple de diffusion dans lequel la couche d'alumine mesure 100 nm environ d'épaisseur tandis que la figure 5C correspond à un couple de diffusion dans lequel la couche d'alumine mesure 400 nm d'épaisseur; à titre de référence, la figure 5D représente une image prise au MEB dans les mêmes conditions et montrant l'interface γ-U(8Mo)/Al d'un couple de diffusion composé d'un substrat massif en un alliage γ-U(8Mo) n'ayant pas été revêtu d'une couche d'alumine, et d'aluminium.
La figure 6A représente une image prise au MEB en mode électrons rétrodiffusés, à un grandissement de 1000, montrant l'interface γ-U(8Mo)/Al d'un couple de diffusion composé d'un substrat massif en un alliage γ-U(8Mo), revêtu d'une couche d'alumine de 50 nm environ d'épaisseur, et d'aluminium, tandis que les figures 6B et 6C représentent les cartographies X, respectivement de l'oxygène et de l'aluminium, ayant été réalisées par MEB couplée à une spectroscopie à dispersion d'énergie (MEB-EDS) au niveau de cette interface.

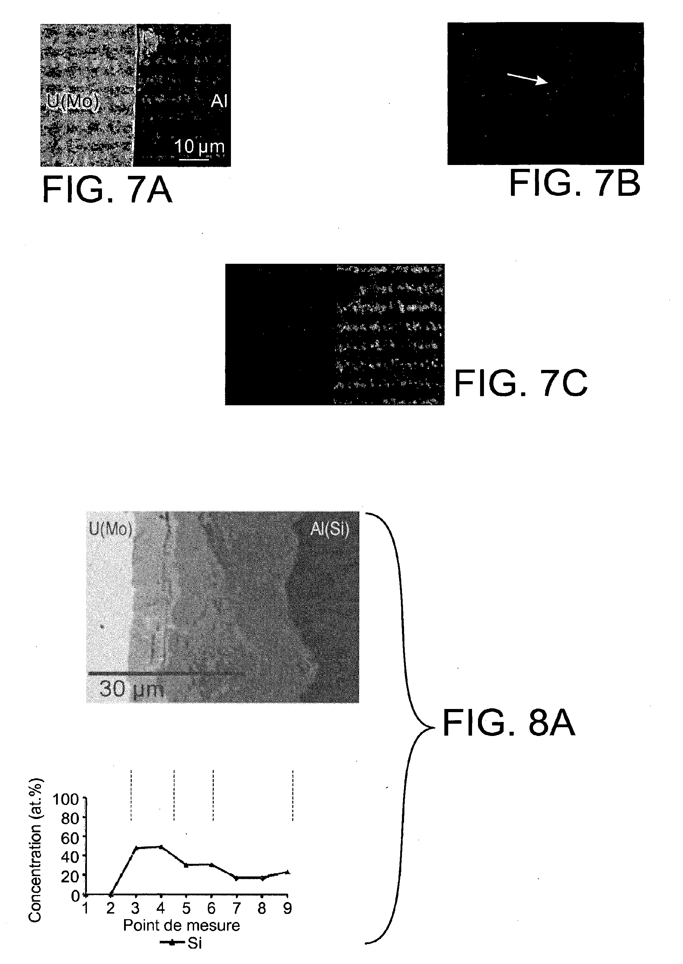

La figure 7A représente une image prise au MEB en mode électrons rétrodiffusés, à un grandissement de 1000, montrant l'interface γ-U(Mo)/Al d'un couple de diffusion composé d'un substrat massif en un alliage γ-U(8Mo), revêtu d'une couche d'alumine de 400 nm environ d'épaisseur, et d'aluminium, tandis que les figures 7B et 7C représentent les cartographies X, respectivement de l'oxygène et de l'aluminium, ayant été réalisées par MEB-EDS au niveau de cette interface.

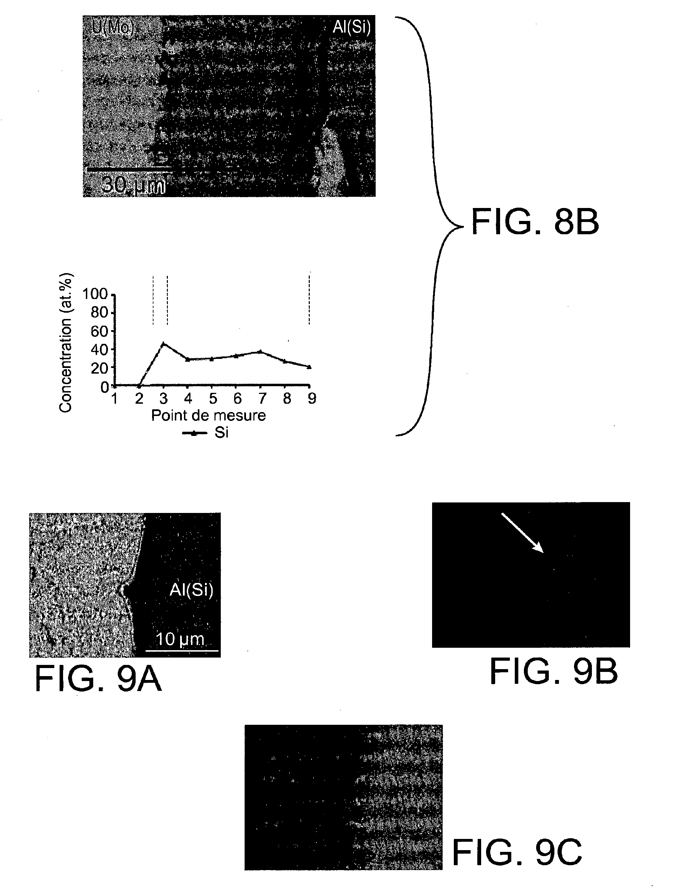

La figure 8A représente une image prise au MEB en mode électrons rétrodiffusés, à un grandissement de 1500, montrant l'interface γ-U(8Mo)/Al(7Si) d'un couple de diffusion composé d'un substrat massif en un alliage γ-U(8Mo), revêtu d'une couche d'alumine de 400 nm environ d'épaisseur, et d'un alliage Al(7Si), ainsi que la cartographie X du silicium ayant été réalisée par MEB-EDS au niveau de cette interface ; à titre de référence, la figure 8B représente une image prise au MEB dans les mêmes conditions montrant l'interface γ-U(8Mo)/Al(7Si) d'un couple de diffusion composé d'un substrat massif en un alliage γ-U(8Mo) n'ayant pas été revêtu d'une couche d'alumine, et d'un alliage Al(7Si), ainsi que la cartographie X du silicium ayant été réalisée par MEB-EDS au niveau de cette interface.
La figure 9A représente une image prise au MEB en mode électrons rétrodiffusés, à un grandissement de 2000, montrant l'interface γ-U(8Mo)/Al(7Si) d'un couple de diffusion composé d'un substrat massif en un alliage γ-U(8Mo), revêtu d'une couche d'alumine de 400 nm environ d'épaisseur, et d'un alliage Al(7Si), tandis que les figures 9B et 9C représentent les cartographies X, respectivement de l'oxygène et de l'aluminium réalisées par MEB-EDS au niveau de cette interface.

### EXPOSÉ DÉTAILLÉ DE MODES DE RÉALISATION PARTICULIERS

### Exemple 1 : Dépôt d'une couche d'alumine sur des substrats massifs en un alliage γ-U(8Mo)

On dépose une couche d'alumine d'une épaisseur de 50, 100 ou 400 nm environ sur des substrats qui mesurent 4 ± 0,5 mm de longueur, 4 ± 0,5 mm de largeur et 1 ± 0,5 mm d'épaisseur et qui sont constitués d'un alliage d'uranium et de molybdène à 8% massique de molybdène en phase γ-métastable (γ-U(8Mo)), par la technique de dépôt par ablation laser (ou « *Pulsed Laser Deposition* »).

Cette technique étant bien connue, on rappelle seulement qu'elle consiste à bombarder, dans une enceinte sous vide, une cible constituée du matériau à déposer avec un faisceau laser pulsé. Lorsque la densité de puissance laser est suffisamment élevée, une certaine quantité de matière est éjectée de la cible, perpendiculairement à sa surface, et se dépose sur un substrat, éventuellement chauffé, situé en vis-à-vis de la cible.

Dans le cas présent, la cible utilisée est une cible d'alumine, la pression régnant dans l'enceinte est de l'ordre de 10⁻⁶ mbar (vide secondaire) et les substrats ne sont pas chauffés pendant les opérations de dépôt par ablation laser.

La surface des substrats est préalablement polie au micron et nettoyée par passage aux ultra-sons dans une succession de bains constitués pour le premier d'eau déminéralisée, pour le second d'éthanol et pour le troisième de cyclohexane, le temps de passage aux ultra-sons étant d'environ 30 secondes pour chaque bain.

Les paramètres opératoires utilisés pour les opérations de dépôt par ablation laser sont présentés dans le tableau ci-après pour chaque épaisseur de couche d'alumine déposée.

| | | | |
|---|---|---|---|
| Epaisseur de la couche d'alumine (nm) | ≈ 50 | ≈ 100 | ≈ 400 |
| Puissance du laser (mJ) | 200 | 200 | 200 |
| Fréquence du laser (Hz) | 2 | 2 | 3 |
| Durée du dépôt (min) | 15 | 30 | 60 |

A l'issue des opérations de dépôt par ablation laser, chaque substrat est soumis à des analyses par microscopie électronique à balayage (MEB), en mode électrons secondaires, en vue :
- d'une part, de mesurer l'épaisseur de la couche d'alumine déposée sur ce substrat, cette mesure étant effectuée par fracturation de cette couche et observation sur sa section transverse ; et
- d'autre part, d'apprécier la qualité du dépôt d'alumine et, en particulier, la présence éventuelle, à la surface de la couche d'alumine, de défauts visibles à l'échelle micrométrique.

Les résultats des mesures d'épaisseur sont illustrés sur les figures 1A, 1B et 1C, tandis que les résultats des observations d'état de surface sont illustrés sur les figures 2A, 2B et 2C.

Comme visible sur ces figures, les couches d'alumine ont bien l'épaisseur attendue (soit environ 50 nm sur la figure 1A, environ 100 nm sur la figure 1B et environ 400 nm sur la figure 1C) et présentent dans tous les cas un état de surface homogène, exempt de défauts à l'échelle micrométrique.

### Exemple 2 : Réactivité chimique de substrats massifs en un alliage γ-U(8Mo), revêtus d'une couche d'alumine, en présence d'aluminium ou d'un alliage Al(7Si)

La réactivité chimique de substrats en alliage γ-U(8Mo) ayant été revêtus d'une couche d'alumine, comme décrit dans l'exemple 1 ci-avant, est testée en présence d'aluminium d'une part, et d'un alliage d'aluminium et de silicium à 7% massique de silicium (Al(7Si)) d'autre part, en couple de diffusion activé par un traitement thermique.

Cette technique expérimentale est justifiée et utilisée pour développer des solutions technologiques pour les combustibles dispersés actuels (références **[13]** et **[14]**).

La réalisation de tests en couple de diffusion nécessite de préparer l'état de surface des pièces en aluminium ou en alliage Al(7Si) destinées à être utilisées dans ces tests. Aussi, après un polissage au micron, l'une des faces d'extrémité de ces pièces, qui se présentent sous la forme de barreaux de 6 ± 0,1 mm de diamètre et de 6 mm de hauteur, est nettoyée de la même façon que celle décrite dans l'exemple 1 ci-avant pour le nettoyage de la surface des substrats en alliage γ-U(8Mo).

Puis, chaque substrat en alliage γ-U(8Mo) revêtu d'une couche d'alumine est déposé sur la face d'extrémité ainsi préparée d'une pièce en aluminium ou en alliage Al(7Si) et encastré dans cette pièce selon le schéma représenté sur la figure 3 dans lequel :
- les références 1 et 1' correspondent à la pièce en aluminium ou en alliage Al(7Si), respectivement avant et après encastrement d'un substrat en alliage γ-U(8Mo) ;
- les références 2 et 2' correspondent au substrat en alliage γ-U(8Mo), respectivement avant et après encastrement de ce substrat ; tandis que
- les références 3 et 3' correspondent à la couche d'alumine revêtant ce substrat, respectivement avant et après encastrement dudit substrat.

On obtient ainsi un compact mesurant 9 mm environ de diamètre sur 3 mm environ de hauteur.

Ce compact est ensuite emballé dans une feuille de tantale de 30 µm d'épaisseur puis inséré entre les mors d'un dispositif de serrage en acier inoxydable, la feuille de tantale étant destinée à éviter toute réaction entre les matériaux du compact et l'acier inoxydable du dispositif de serrage. Ce dernier est alors serré avec un couple de 4 ± 0,04 N.m au moyen d'une clef dynamométrique et d'une douille torque n°6.

Puis l'ensemble compact/dispositif de serrage est placé dans un four tubulaire sous une atmosphère réductrice composée d'argon et d'hydrogène dans un rapport volumique 95/5.

La température et le temps de recuit sont déterminés sur la base du diagramme TTT (Température - Temps - Transformation) montré sur la figure 4 de manière à ce que l'alliage γ-U(8Mo) ne subisse pas une décomposition eutectoïde.

Dans le cadre de tests de réactivité chimique en couple de diffusion, la température et le temps de recuit sont également choisis de manière à ce que ces paramètres soient suffisamment sollicitants pour activer la diffusion entre les matériaux constituant le couple de diffusion.

Une température et des temps de recuit satisfaisant à ces deux conditions sont, dans le cas présent, une température de 600°C et des temps allant de 0,5 à 4 heures.

A titre de références, les tests de réactivité chimique effectués avec les substrats en alliage γ-U(8Mo) revêtus d'une couche d'alumine sont également réalisés, dans des conditions expérimentales strictement identiques, avec des substrats qui sont également en alliage γ-U(8Mo) mais sur lesquels n'a pas été déposée de couche d'alumine.

Dans tous les cas, les couples de diffusion sont soumis au terme du recuit à des analyses par MEB, en mode électrons rétrodiffusés, couplées à des analyses par spectroscopie à dispersion d'énergie, plus connue sous le sigle EDS (de « ***E**nergy **D**ispersive **S**pectroscopy* ») en vue :
- d'une part, de déterminer si une zone d'interaction s'est formée aux interfaces γ-U(8Mo)/Al ou γ-U(8Mo)/Al(7Si) et, le cas échéant, de mesurer l'épaisseur de cette zone d'interaction ;
- d'autre part, de cartographier l'oxygène et l'aluminium présents au niveau des interfaces γ-U(8Mo)/Al ou γ-U(8Mo)/Al(7Si) des couples de diffusion dont le substrat en alliage γ-U(8Mo) a été revêtu d'une couche d'alumine et ce, de manière à localiser cette couche d'alumine ; et
- enfin, de cartographier le silicium présent au niveau des interfaces γ-U(8Mo)/Al(7Si) des couples de diffusion comprenant un alliage Al(7Si).

Les résultats de ces analyses sont présentés sur les figures 5A à 9C qui correspondent aux couples de diffusion suivants :
figure 5A : γ-U(8Mo)/Al₂O₃/Al avec Al₂O₃ ≈ 50 nm ;
figure 5B : γ-U(8Mo)/Al₂O₃/Al avec Al₂O₃ ≈ 100 nm ;
figure 5C : γ-U(8Mo)/Al₂O₃/Al avec Al₂O₃ ≈ 400 nm ;
figure 5D : γ-U(8Mo)/Al, servant de référence aux trois couples précédents ;
figures 6A, 6B et 6C : γ-U(8Mo)/Al₂O₃/Al avec Al₂O₃ ≈ 50 nm ;
figures 7A, 7B et 7C : γ-U(8Mo)/Al₂O₃/Al avec Al₂O₃ ≈ 400 nm ;
figure 8A : γ-U(8Mo)/Al₂O₃/Al(7Si) avec Al₂O₃ ≈ 400 nm ;
figure 8B : γ-U(8Mo)/Al(7Si), servant de référence au couple de diffusion de la figure 8A; et
figures 9A, 9B et 9C : γ-U(8Mo)/Al₂O₃/Al(7Si) avec Al₂O₃ ≈ 400 nm.

Tous ces couples de diffusion ont été traités pendant 4 heures à 600°C, soit une température plus élevée que celles qui sont susceptibles d'être appliquées aux éléments combustibles nucléaires que ce soit lors de leur fabrication ou de leur irradiation en réacteur MTR.

Comme le montrent les figures 5A à 5D, 6A et 7A, une zone d'interaction est observée à l'interface U(8Mo)/Al dans le couple de diffusion γ-U(8Mo)/Al₂O₃/Al avec Al₂O₃ 50 nm (figures 5A et 6A) ainsi que dans le couple de diffusion de référence γ-U(8Mo)/Al (figure 5D). Par contre, cette zone d'interaction est absente dans les couples de diffusion γ-U(8Mo)/Al₂O₃/Al avec Al₂O₃ ≈ 100 nm (figure 5B) et Al₂O₃ ≈ 400 nm (figures 5C et 7A).

Par ailleurs, l'épaisseur de la zone d'interaction n'est que de 20 µm dans le couple de diffusion γ-U(8Mo)/Al₂O₃/Al avec Al₂O₃ ≈ 50 nm (figures 5A et 6A) alors qu'elle atteint 275 µm dans le couple de diffusion de référence γ-U(8Mo)/Al (figure 5D).

La présence d'une couche d'alumine permet donc de réduire l'épaisseur de la zone d'interaction qui se forme, sous l'effet d'un traitement thermique, entre l'alliage γ-U(8Mo) et la matrice d'aluminium dans laquelle est dispersé cet alliage et permet même de supprimer l'existence de cette zone d'interaction lorsque ladite couche d'alumine mesure de l'ordre de 100 nm d'épaisseur ou davantage.

Par ailleurs, comme le montrent les figures 6B et 7B, les cartographies X de l'oxygène et de l'aluminium mettent en évidence l'existence d'une fine couche d'alumine, qui est matérialisée par une flèche sur les figures 6B et 7B, et qui est située du côté de l'aluminium dans le couple de diffusion γ-U(8Mo)/Al₂O₃/Al avec Al₂O₃ ≈ 50 nm, et à l'interface γ-U(8Mo)/ aluminium dans le couple de diffusion γ-U(8Mo)/Al₂O₃/Al avec Al₂O₃ ≈ 400 nm.

Si l'on se réfère à présent aux figures 8A, 8B et 9A, on constate que l'épaisseur de la zone d'interaction qui se forme, sous l'effet d'un traitement thermique, entre l'alliage γ-U(8Mo) et la matrice d'alliage Al(7Si) dans laquelle est dispersé l'alliage γ-U(8Mo) est peu différente selon que les particules d'alliage γ-U(8Mo) sont ou non revêtues d'une couche d'alumine (30-35 µm *versus* 30 µm).

De même, on constate qu'une stratification particulière en couches différemment enrichies en silicium se développe dans cette zone d'interaction et ce, que les particules d'alliage γ-U(8Mo) soient ou non revêtues d'une couche d'alumine.

Par contre, on note la présence, dans la zone d'interaction du couple de diffusion γ-U(8Mo)/ Al₂O₃/Al(7Si) avec Al₂O₃ ≈ 400 nm, d'une couche enrichie en silicium à hauteur de 51% atomique environ, qui présente une épaisseur de l'ordre de 10 µm.

Cette couche est donc plus riche en silicium et trois fois plus épaisse que la couche la plus riche en silicium que comporte le couple de diffusion de référence γ-U(8Mo)/Al(7Si) et dont l'enrichissement en silicium ne dépasse pas 46% atomique de silicium sur une épaisseur de 2 à 3 µm.

Enfin, comme le montrent les figures 9B et 9C, les cartographies X de l'oxygène et de l'aluminium mettent en évidence l'existence d'une fine couche d'alumine (mise en évidence par une flèche sur la figure 9B) du côté de l'alliage Al(7Si) dans le couple de diffusion γ-U(8Mo)/Al₂O₃/Al(7Si) avec Al₂O₃ ≈ 400 nm.

Dans l'exemple qui vient d'être décrit, la réactivité chimique des substrats en alliage γ-U(8Mo) a été testée en appliquant aux différents couples de diffusion une température plus élevée que celles qui sont susceptibles d'être appliquées aux éléments combustibles nucléaires à la fois lors de leur fabrication et lors de leur irradiation en réacteur MTR. On peut donc prédire que les bénéfices procurés par la présence d'une couche d'alumine sur les substrats en alliage γ-U(8Mo), tels qu'observés dans cet exemple, seront également obtenus lors de la mise en oeuvre industrielle de l'invention mais pour des couches d'alumine sensiblement inférieures à celles utilisées dans ledit exemple.

### REFERENCES CITEES

[1] M. K. Meyer et al., J. Nuclear Mater. 304 (2002) 221
[2] G. L. Hofman et al., RERTR 2003, Chicago, USA
[3] A. Leenaers et al., J. Nuclear Mater. 335 (2004) 39
[4] F. Huet et al. in : The Proceedings of the 9th International Topical Meeting on Research Reactor Fuel Management (RRFM) 2005, Budapest, Hongrie
[5] A. Leenaers et al. in : The Proceedings of the 12th International Topical Meeting on Research Reactor Fuel Management (RRFM) 2008, Hambourg, Allemagne
[6] D. D. Keyser et al. in : The Proceedings of the 13th International Topical Meeting on Research Reactor Fuel Management (RRFM) 2009, Vienne, Autriche
[7] Y. S. Kim et al. in : The Proceedings of the 13th International Topical Meeting on Research Reactor Fuel Management (RRFM) 2009, Vienne, Autriche
**[8]** M. Ripert et al. in : The Proceedings of the 15th International Topical Meeting on Research Reactor Fuel Management (RRFM) 2011, Rome, Italie
[9] Demande de brevet français n° 2 777 688
**[10]** Brevet US n° 4,915,987
[11] Brevet US n° 5,978,432
[12] Demande de brevet japonais n° 55-054508
[12] J. Allenou et al., J. Nuclear Mater. 399 (2010) 189
[14] M. Mirandou et al., J. Nuclear. Mater. 384 (2009) 268

## Revendications

1. Poudre d'un alliage à base d'uranium et comprenant du molybdène, en phase γ-métastable, qui est formée de particules comportant un coeur qui est constitué dudit alliage et qui est revêtu d'une couche d'alumine située au contact de ce coeur.

2. Poudre selon la revendication 1, dans laquelle la couche d'alumine a une épaisseur d'au moins 50 nm.

3. Poudre selon la revendication 2, dans laquelle la couche d'alumine a une épaisseur allant de 50 nm à 3 µm.

4. Poudre selon l'une quelconque des revendications précédentes, dont les particules ont des dimensions allant de 1 µm à 300 µm.

5. Poudre selon l'une quelconque des revendications précédentes, dans laquelle l'alliage à base d'uranium et comprenant du molybdène est un alliage binaire d'uranium et de molybdène.

6. Poudre selon la revendication 5, dans laquelle la teneur massique en molybdène de l'alliage va de 5 à 15%.

7. Poudre selon l'une quelconque des revendications 1 à 4, dans laquelle l'alliage à base d'uranium et comprenant du molybdène est un alliage ternaire d'uranium, de molybdène et d'un élément chimique X autre que l'uranium et le molybdène.

8. Poudre selon la revendication 7, dans laquelle l'élément chimique X est choisi parmi les métaux et les semi-conducteurs.

9. Poudre selon la revendication 7 ou la revendication 8, dans laquelle la teneur massique en molybdène de l'alliage va de 5 à 15%, tandis que la teneur massique en élément chimique X est au plus de 6%.

10. Composition de poudres, qui comprend une poudre d'un alliage à base d'uranium et comprenant du molybdène, en phase γ-métastable, selon l'une quelconque des revendications 1 à 9, mélangée à une poudre comprenant de l'aluminium.

11. Composition de poudres selon la revendication 10, dans laquelle la poudre comprenant de l'aluminium a une teneur massique en aluminium au moins égale à 80%.

12. Composition de poudres selon la revendication 10, dans laquelle la poudre comprenant de l'aluminium est une poudre d'aluminium ou une poudre d'un alliage comprenant de l'aluminium et du silicium.

13. Composition de poudres selon la revendication 12, dans laquelle la teneur massique en aluminium de l'alliage comprenant de l'aluminium et du silicium va de 88 à 98% tandis que la teneur massique en silicium de l'alliage comprenant de l'aluminium et du silicium va de 2 à 12%.

14. Composition de poudres selon l'une quelconque des revendications 10 à 13, dans laquelle la poudre d'alliage à base d'uranium et comprenant du molybdène représente de 65 à 90% massiques de la composition de poudres.

15. Utilisation d'une poudre d'un alliage à base d'uranium et comprenant du molybdène, en phase γ-métastable, selon l'une quelconque des revendications 1 à 9, ou d'une composition de poudres selon l'une quelconque des revendications 10 à 14, pour la fabrication d'un élément combustible nucléaire.

16. Utilisation d'une poudre d'un alliage à base d'uranium et comprenant du molybdène, en phase γ-métastable, selon l'une quelconque des revendications 1 à 9, ou d'une composition de poudres selon l'une quelconque des revendications 10 à 14, pour la fabrication d'une cible destinée à la production d'un radioélément.

17. Procédé de fabrication d'un élément combustible nucléaire ou d'une cible pour la production d'un radioélément, qui comprend le remplissage d'une gaine avec une composition de poudres selon l'une quelconque des revendications 10 à 14, et l'application d'au moins un traitement thermique à l'ensemble ainsi obtenu.

18. Procédé de fabrication selon la revendication 17, dans lequel la poudre comprenant de l'aluminium qui est présente dans la composition de poudres est une poudre d'aluminium.

19. Elément combustible nucléaire ou cible pour la production d'un radioélément, qui est obtenu(e) par un procédé selon la revendication 18, qui comprend une gaine dans laquelle est logée une âme, et dans lequel l'âme est formée d'une matrice en aluminium dans laquelle sont dispersées des particules, ces particules comportant un coeur qui est constitué d'un alliage à base d'uranium et comprenant du molybdène, en phase γ-métastable, et qui est revêtu d'une couche d'alumine située au contact de ce coeur.

20. Procédé de fabrication selon la revendication 17, dans lequel la poudre comprenant de l'aluminium qui est présente dans la composition de poudres est une poudre d'un alliage comprenant de l'aluminium et du silicium.

21. Elément combustible nucléaire ou cible pour la production d'un radioélément, qui est obtenu(e) par un procédé selon la revendication 20, qui comprend une gaine dans laquelle est logée une âme, et dans lequel l'âme est formée d'une matrice comprenant de l'aluminium et du silicium et dans laquelle sont dispersées des particules, ces particules comportant un coeur qui est constitué d'un alliage à base d'uranium et comprenant du molybdène, en phase γ-métastable, et qui est revêtu d'une couche contenant de l'uranium, du molybdène, de l'aluminium et du silicium, qui est située au contact de ce coeur, dont la teneur en silicium est au moins égale à 50% atomique au contact dudit coeur et qui est elle-même revêtue d'une couche d'alumine.

22. Elément combustible nucléaire ou cible pour la production d'un radioélément selon la revendication 19 ou la revendication 21, qui se présente sous la forme d'une plaque ou d'un crayon.

## Patentansprüche

1. Pulver aus einer Legierung auf Basis von Uran und Molybdän enthaltend in einer gamma-metastabilen Phase, das gebildet ist aus Partikeln, umfassend einen Kern, der aus der Legierung gebildet ist, und der bedeckt ist mit einer Aluminiumoxidschicht, die sich in Kontakt mit diesem Kern befindet.

2. Pulver nach Anspruch 1, bei dem die Aluminiumoxidschicht eine Dicke von wenigstens 50nm hat.

3. Pulver nach Anspruch 2, bei dem die Aluminiumoxidschicht eine Dicke von 50nm bis 3µm hat.

4. Pulver nach einem der vorhergehenden Ansprüche, dessen Partikel Abmessungen von 1µm bis 300µm haben.

5. Pulver nach einem der vorhergehenden Ansprüche, bei dem die Legierung auf Basis von Uran und Molybdän enthaltend eine binäre Uran-Molybdän-Legierung ist.

6. Pulver nach Anspruch 5, bei dem der Massengehalt des Molybdäns der Legierung von 5 bis 15% beträgt.

7. Pulver nach einem der Ansprüche 1 bis 4, bei dem die Legierung auf Basis von Uran und Molybdän enthaltend eine ternäre Legierung von Uran, Molybdän und einem chemischen Element X ist, welches von Uran und Molybdän verschieden ist.

8. Pulver nach Anspruch 7, bei dem das chemische Element X ausgewählt ist aus den Metallen und den Halbleitern.

9. Pulver nach Anspruch 7 oder Anspruch 8, bei dem der Massengehalt von Molybdän der Legierung von 5 bis 15% beträgt, wohingegen der Massengehalt des chemischen Elements X höchstens 6% beträgt.

10. Zusammensetzung von Pulvern, die ein Pulver aus einer Legierung auf Basis von Uran und Molybdän enthaltend in einer gamma-metastabilen Phase nach einem der Ansprüche 1 bis 9 umfaßt, gemischt mit einem Pulver, das Aluminium enthält.

11. Zusammensetzung von Pulvern nach Anspruch 10, bei der das Pulver, das Aluminium enthält, einen Massengehalt von Aluminium von wenigstens gleich 80% hat.

12. Zusammensetzung von Pulvern nach Anspruch 10, bei der das Pulver, das Aluminium enthält, ein Aluminiumpulver oder ein Pulver aus einer Legierung ist, die Aluminium und Silizium enthält.

13. Zusammensetzung von Pulvern nach Anspruch 12, bei der der Massengehalt von Aluminium der Legierung, die Aluminium und Silizium enthält, von 88 bis 98% beträgt, wohingegen der Massengehalt von Silizium der Legierung, die Aluminium und Silizium enthält, von 2 bis 12% beträgt.

14. Zusammensetzung von Pulvern nach einem der Ansprüche 10 bis 13, bei der das Pulver aus einer Legierung auf Basis von Uran und Molybdän enthaltend 65 bis 90 Massenprozent der Zusammensetzung von Pulvern repräsentiert.

15. Verwendung eines Pulvers aus einer Legierung auf Basis von Uran und Molybdän enthaltend in einer gamma-metastabilen Phase nach einem der Ansprüche 1 bis 9 oder einer Zusammensetzung von Pulvern nach einem der Ansprüche 10 bis 14 für die Herstellung eines Kernbrennstoffelements.

16. Verwendung eines Pulvers aus einer Legierung auf Basis von Uran und Molybdän enthaltend in einer gamma-metastabilen Phase nach einem der Ansprüche 1 bis 9 oder einer Zusammensetzung von Pulvern nach einem der Ansprüche 10 bis 14 für die Herstellung eines Targets, das für die Produktion eines Radioelements bestimmt ist.

17. Verfahren zur Herstellung eines Kernbrennstoffelements oder eines Targets für die Herstellung eines Radioelements, das das Befüllen einer Hülle mit einer Zusammensetzung von Pulvern nach einem der Ansprüche 10 bis 14 und die Anwendung wenigstens einer thermischen Behandlung auf die derart erhaltene Gesamtanordnung umfaßt.

18. Verfahren zur Herstellung nach Anspruch 17, bei dem das Pulver, das Aluminium enthält, das in der Zusammensetzung von Pulvern vorhanden ist, ein Aluminiumpulver ist.

19. Kernbrennstoffelement oder Target für die Herstellung eines Radioelements, das durch ein Verfahren nach Anspruch 18 erhalten ist, das eine Hülle umfaßt, in der eine Seele aufgenommen ist, und wobei die Seele gebildet ist durch eine Aluminiummatrix, in der Partikel dispergiert sind, wobei diese Partikel einen Kern umfassen, der gebildet ist durch eine Legierung auf Basis von Uran und Molybdän enthaltend in einer gamma-metastabilen Phase, und der mit einer Aluminiumoxidschicht bedeckt ist, die in Kontakt mit diesem Kern angeordnet ist.

20. Verfahren zur Herstellung nach Anspruch 17, bei dem das Pulver, das Aluminium enthält, das in der Zusammensetzung von Pulvern vorhanden ist, ein Pulver aus einer Legierung ist, die Aluminium und Silizium enthält.

21. Kernbrennstoffelement oder Target für die Produktion eines Radioelements, das erhalten ist durch ein Verfahren nach Anspruch 20, das eine Hülle umfaßt, in der eine Seele aufgenommen ist, und wobei die Seele durch eine Matrix gebildet ist, die Aluminium und Silizium enthält, und in der Partikel dispergiert sind, wobei diese Partikel einen Kern umfassen, der gebildet ist aus einer Legierung auf Basis von Uran und Molybdän enthaltend in einer gamma-metastabilen Phase, und der mit einer Schicht bedeckt ist, die Uran, Molybdän, Aluminium und Silizium enthält, die in Kontakt mit diesem Kern angeordnet ist, deren Siliziumgehalt wenigstens gleich 50 Atomprozent im Kontakt mit diesem Kern ist, und die selbst wiederum mit einer Aluminiumoxidschicht bedeckt ist.

22. Kernbrennstoffelement oder Target für die Produktion eines Radioelements nach Anspruch 19 oder Anspruch 21, das die Form einer Platte oder eines Stabs aufweist.

## Claims

1. Powder of an alloy based on uranium and comprising molybdenum, in γ-metastable phase, which is formed of particles comprising a nucleus which consists of said alloy and which is covered with a layer of alumina positioned in contact with this nucleus.

2. Powder according to claim 1, wherein the layer of alumina is at least 50 nm thick.

3. Powder according to claim 2, wherein the layer of alumina is from 50 nm to 3 µm thick.

4. Powder according to any one of the previous claims, the particles of which have dimensions ranging from 1 µm to 300 µm.

5. Powder according to any one of the previous claims, wherein the alloy based on uranium and comprising molybdenum is a binary alloy of uranium and molybdenum.

6. Powder according to claim 5, wherein the mass molybdenum content of the alloy ranges from 5 to 15%.

7. Powder according to any one of claims 1 to 4, wherein the alloy based on uranium and comprising molybdenum is a ternary alloy of uranium, molybdenum and a chemical element X other than uranium and molybdenum.

8. Powder according to claim 7, wherein the chemical element X is chosen from among the metals and the semiconductors.

9. Powder according to claim 7 or claim 8, wherein the mass molybdenum content of the alloy ranges from 5 to 15%, while the mass content of the chemical element X is at most 6%.

10. Composition of powders, which comprises a powder of an alloy based on uranium and comprising molybdenum, in γ-metastable phase, according to any one of claims 1 to 9, blended with a powder comprising aluminium.

11. Composition of powders according to claim 10, wherein the powder comprising aluminium has a mass aluminium content at least equal to 80%.

12. Composition of powders according to claim 10, wherein the powder comprising aluminium is an aluminium powder or a powder of an alloy comprising aluminium and silicon.

13. Composition of powders according to claim 12, wherein the mass aluminium content of the alloy comprising aluminium and silicon ranges from 88 to 98%, while the mass silicon content of the alloy comprising aluminium and silicon ranges from 2 to 12%.

14. Composition of powders according to any one of claims 10 to 13, wherein the alloy powder based on uranium and comprising molybdenum represents 65 to 90% by mass of the composition of powders.

15. Use of a powder of an alloy based on uranium and comprising molybdenum, in γ-metastable phase, according to any one of claims 1 to 9, or of a composition of powders according to any one of claims 10 to 14, for manufacturing a nuclear fuel element.

16. Use of a powder of an alloy based on uranium and comprising molybdenum, in γ-metastable phase, according to any one of claims 1 to 9, or of a composition of powders according to any one of claims 10 to 14, for manufacturing a target intended for the production of a radioelement.

17. Method for manufacturing a nuclear fuel element or of a target for the production of a radioelement, which comprises filling a sheath with a composition of powders according to any one of claims 10 to 14, and applying at least one heat treatment to the assembly so obtained.

18. Method for manufacturing according to claim 17, wherein the powder comprising aluminium which is present in the composition of powders is an aluminium powder.

19. Nuclear fuel element or target for producing a radioelement, which is obtained by a method according to claim 18, which comprises a sheath in which a core is held, and wherein the core is formed from an aluminium matrix within which particles are dispersed, these particles comprising a nucleus which consists of an alloy based on uranium and comprising molybdenum, in γ-metastable phase, and which is covered by an alumina layer positioned in contact with this nucleus.

20. Method for manufacturing according to claim 17, wherein the powder comprising aluminium which is present in the composition of powders is a powder of an alloy comprising aluminium and silicon.

21. Nuclear fuel element or target for producing a radioelement, which is obtained by a method according to claim 20, which comprises a sheath in which a core is held, and wherein the core is formed from a matrix comprising aluminium and silicon within which particles are dispersed, these particles comprising a nucleus which consists of an alloy based on uranium and comprising molybdenum, in γ-metastable phase, and which is covered by a layer comprising uranium, molybdenum, aluminium and silicon, positioned in contact with this nucleus, the atomic silicon content of which is at least equal to 50% at the contact with said nucleus, the layer being itself covered with an alumina layer.

22. Nuclear fuel element or target for producing a radioelement according to claim 19 or claim 21, which takes the form of a plate or a rod.
